# EUROPEAN PATENT APPLICATION

(11) **EP 4 279 930 A1**
(43) Date of publication of application: **22.11.2023**
(21) Application number: 22174053.3
(22) Date of filing: 18.05.2022
(51) Int. Cl.: G01R 31/3185, G01R 31/302

(54) **BOUNDARY SCAN FOR REAL-TIME STATUS MONITORING**

(71) Applicant: B/E Aerospace, Inc., Winston-Salem, NC 27105 (US)
(72) Inventor: HUIJSING, Hans, 3404 KD IJsselstein, UT (NL); PEREZ CAMACHO, Manuel, 3431 BH Nieuwegein, UT (NL)
(74) Representative: Dehns

(57) **Abstract**

A method for performing boundary scan for live status monitoring of a circuit is described. The method comprises performing a boundary scan on a primary boundary scan compatible device (214), through a set of pins (216) on a first circuit (210), providing a JTAG port (218) on the first circuit (210) for sending/receiving data to/from the set of pins (216), providing a secondary central processing unit, CPU, (224) on a second circuit (220), and connecting the second circuit to the JTAG port (218) to retrieve data from the primary boundary scan compatible device. The method further includes storing and/or analysing the data on the secondary CPU.

## Description

### TECHNICAL FIELD

This disclosure relates to boundary scan for integrated circuits. In particular, this disclosure relates to boundary scan for live status monitoring.

### BACKGROUND

Boundary scan is a method for electronics testing and programming, defined by the Joint Test Action Group (JTAG). JTAG developed a specification for boundary scan that was standardized as the IEEE 1149.1 and a boundary scan performed according to this standard is referred to as a JTAG boundary scan, or simply JTAG. JTAG is applied to testing and programming of, for example, an integrated circuit (IC).

Although JTAG is used most commonly in production testing, there is a need for utilising JTAG for live status monitoring of electronics.

### SUMMARY

In one aspect, there is provided a method for performing boundary scan for live status monitoring of a circuit. The method includes performing a boundary scan on a primary boundary scan compatible device, through a set of pins on a first circuit, providing a JTAG port on the first circuit for sending/receiving data to/from the set of pins. The method further includes providing a secondary central processing unit, CPU, on a second circuit, and connecting the second circuit to the JTAG port to retrieve data from the primary boundary scan compatible device, and storing and/or analysing the data on the secondary CPU.

Retrieving data from the primary boundary scan compatible device may be performed whilst the primary boundary scan compatible device is in use.

Further, the secondary CPU may include a communication device to transmit the data to an external source. The communication device may be a wired communication device or a wireless communication device.

The first circuit may include circuit logic, and the method may further comprise updating the set of pins to modify, reprogram and/or reset the circuit logic. The secondary CPU may communicate modifications to the JTAG port to update the set of pins.

The primary boundary scan compatible device may be a primary CPU.

In another aspect, a JTAG system for performing the method as above is provided. The system comprises a first circuit having a set of pins, a primary boundary scan compatible device and a JTAG port. The system further includes a second circuit having a secondary CPU.

The secondary CPU may be configured to retrieve data from the primary boundary scan compatible device whilst the primary boundary scan compatible device is in use.

The secondary CPU may include a communication device configured to transmit the data to an external source. The communication device may be a wired communication device or a wireless communication device.

The first circuit may include circuit logic, and the secondary CPU may be configured to update the set of pins to modify, reprogram and/or reset the circuit logic.

The secondary CPU may be configured to communicate modifications to the JTAG port to update the set of pins.

The primary boundary scan compatible device may be a primary CPU.

### BRIEF DESCRIPTION OF THE DRAWINGS

Figure 1 shows a JTAG system.
Figure 2 shows an example of a JTAG system in accordance with the present disclosure.

### DETAILED DESCRIPTION

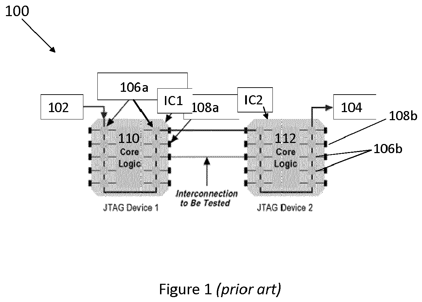

Figure 1 shows a known example of a JTAG system 100. The JTAG system 100 includes a first JTAG device (labelled JTAG Device 1) and a second JTAG device (labelled JTAG Device 2). Of course, there may be just one JTAG device, or more than two JTAG devices, present in the JTAG system 100. The first JTAG device includes a core logic 110 provided on an integrated circuit IC1. A set of boundary scan cells 106a is provided on the integrated circuit IC1. The second JTAG device includes a core logic 112 provided on an integrated circuit IC2. A set of boundary scan cells 106b is provided on the integrated circuit IC2.

A set of pins 108a is provided on integrated circuit IC1 and a set of pins 108b is provided on integrated circuit IC2 to provide pin signals. A serial input 102 is provided to the first JTAG device through the boundary scan cells 106a and to a data output, which passes to a data input on the second JTAG device to pass through the boundary scan cells 106b to a serial output 104. The data provided on the boundary scan cells 106a, 106b can then be tested to ensure that the sets of pins 108a, 108b are functioning in an expected manner.

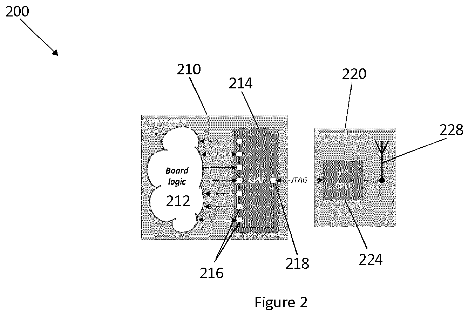

Figure 2 shows an example of a JTAG system 200. The JTAG system 200 may include a first circuit 210 and a second circuit 220. The first circuit 210 may be included in a variety of applications and, as an example, may be provided in aircraft ovens, but this disclosure is not limited to aircraft ovens. The first circuit 210 may include circuit logic 212. The first circuit 210 may also include a primary boundary scan compatible device, such as a primary central processing unit (CPU) 214, or any other boundary scan compatible device. A set of pins 216 may be included on the primary CPU 214 to send and/or receive data from the circuit logic 212. As mentioned above, JTAG provides testing and/or programming of an IC normally during manufacturing. The JTAG system 200 allows for live status monitoring of the first circuit 210 by providing a JTAG port 218 that retrieves up-to-date data from the set of pins 216. Further, the JTAG port 218 can act as a port for incoming data to further update the set of pins 216 to modify, reprogram and/or reset the circuit logic 212. In this way, the primary CPU 214 supports boundary scan through the set of pins 216 and the primary CPU 214 does not need to be altered in any way, as the modifications can be provided through the JTAG port 218. For example, no software or behavioural changes need to be implemented on the primary CPU 214.

The second circuit 220 may include a secondary CPU 224 that can be connected to the JTAG port 218 to retrieve data from the set of pins 216. The secondary CPU 224 may store and analyse the data retrieved from the set of pins 216. The second circuit 220 may further include a communication device 228 (for example, an antenna or the like) configured to transmit the stored and/or analysed data to an external source (not shown). The communication device 228 may be a wired communication device or a wireless communication device. The secondary CPU 224 may also communicate modifications to the JTAG port 218 for updating the set of pins 216 of the first circuit 210. The secondary CPU 224 may be physically or wirelessly connected to JTAG port 218. In this way, the second circuit 220 can take data from the set of pins 216 whilst the first circuit 210 is in use. This therefore provides live status monitoring of the first circuit 210 such that the primary CPU 214 does not need to be interrupted in use. This allows for the second circuit 220 to determine efficiently if there is a fault on the first circuit 210 or whether updates are required. Connecting the secondary CPU 224 to the JTAG port 218 allows for input/output data from the set of pins 216 of the primary CPU 214 to be read back, analysed and stored on the secondary CPU 224, which can be done without disturbing the primary CPU 214.

The JTAG system 200 is particularly useful for insert products of an aircraft that are targeted for remote diagnostics and/or health and usage monitoring systems (HUMS). For example, the secondary CPU 224 and second circuit 220 could be connected to an ecosystem of an aircraft. In this way, the secondary CPU 224 can monitor the inputs/outputs of the set of pins 216 whilst the primary CPU 214 is functioning and forward the data collected from the JTAG port 218 to the ecosystem. In this way, the operation of the primary CPU 214 will not be affected and there is no need to update the software on the primary CPU 214 to support monitoring of the first circuit 210.

Although this disclosure has been described in terms of preferred examples, it should be understood that these examples are illustrative only and that the claims are not limited to those examples. Those skilled in the art will be able to make modifications and alternatives in view of the disclosure which are contemplated as falling within the scope of the appended claims.

## Claims

1. A method for performing boundary scan for live status monitoring of a circuit, the method comprising:
performing a boundary scan on a primary boundary scan compatible device (214), through a set of pins (216) on a first circuit (210);
providing a JTAG port (218) on the first circuit (210) for sending/receiving data to/from the set of pins (216);
providing a secondary central processing unit, CPU, (224) on a second circuit (220), and connecting the second circuit to the JTAG port (218) to retrieve data from the primary boundary scan compatible device;
storing and/or analysing the data on the secondary CPU.

2. The method of claim 1, wherein retrieving data from the primary boundary scan compatible device (214) is performed whilst the primary boundary scan compatible device is in use.

3. The method of claim 1 or 2, wherein the secondary CPU (224) includes a communication device (228) to transmit the data to an external source.

4. The method of claim 3, wherein the communication device (228) is a wired communication device.

5. The method of claim 3, wherein the communication device (228) is a wireless communication device.

6. The method of any preceding claim, wherein the first circuit (210) includes circuit logic, and wherein the method further comprises updating the set of pins (216) to modify, reprogram and/or reset the circuit logic (212).

7. The method of claim 6, wherein the secondary CPU (224 communicates modifications to the JTAG port (218) to update the set of pins (216).

8. The method of any preceding claim, wherein the primary boundary scan compatible device is a primary CPU (214).

9. A JTAG system (200) for performing the method as claimed in claim 1, the system comprising:
a first circuit (210) having a set of pins (216), a primary boundary scan compatible device (214) and a JTAG port (218);
a second circuit (220) having a secondary CPU (224).

10. The JTAG system of claim 9, wherein the secondary CPU (224) is configured to retrieve data from the primary boundary scan compatible device (214) whilst the primary boundary scan compatible device is in use.

11. The JTAG system of claim 9 or 10, wherein the secondary CPU (224) includes a communication device (228) configured to transmit the data to an external source.

12. The JTAG system of claim 11, wherein the communication device (228) is a wired communication device; or wherein the communication device (228) is a wireless communication device.

13. The JTAG system of any of claims 9-12, wherein the first circuit (210) includes circuit logic, and wherein the secondary CPU (224) is configured to update the set of pins (216) to modify, reprogram and/or reset the circuit logic (212).

14. The JTAG system of claim 13, wherein the secondary CPU (224) is configured to communicate modifications to the JTAG port (218) to update the set of pins (216).

15. The JTAG system of any of claims 9-14, wherein the primary boundary scan compatible device is a primary CPU (214).
